Europäisches Patentamt

European Patent Office

Office européen des brevets

(19)

(11) Numéro de publication: **0 110 776**
**A1**

# (12) DEMANDE DE BREVET EUROPEEN

(21) Numéro de dépôt: **83402258.4**

(22) Date de dépôt: **23.11.83**

(51) Int. Cl.³: **H 03 K 17/725,** H 03 K 17/78

(30) Priorité: **25.11.82 FR 8219729**
**01.03.83 FR 8303306**

(43) Date de publication de la demande: **13.06.84**
**Bulletin 84/24**

(84) Etats contractants désignés: **AT BE CH DE FR GB IT LI NL SE**

(71) Demandeur: **LA TELEMECANIQUE ELECTRIQUE, 33 bis, avenue du Maréchal Joffre, F-92000 Nanterre (FR)**

(72) Inventeur: **Thire, Jacques Emile, 19, Allée du Nice Caennais, F-14000 Caen (FR)**
Inventeur: **Souques, Georges, 5, Place de Rungis, F-75013 Paris (FR)**

(74) Mandataire: **Marquer, Francis, CABINET MOUTARD 35, avenue Victor Hugo Résidence Champfleury, F-78180 Voisins le Bretonneux (FR)**

(54) **Circuit de commande d'un dispositif à semi-conducteur sensible du type thyristor ou triac, avec impédance d'assistance à l'auto-allumage.**

(57) Circuit de commande d'un dispositif à semi-conducteur (SC), comportant des moyens interrupteurs (M) aptes à établir un court-circuit entre la gâchette et la cathode dudit dispositif sous l'action d'une commande extérieure, caractérisé par une résistance (R$_{Ga}$) d'assistance à l'auto-allumage reliant le pôle positif du circuit (A) à sa sortie de commande de gâchette (G).

- 1 -

CIRCUIT DE COMMMANDE D'UN DISPOSITIF A SEMI-CONDUCTEUR SENSIBLE DU TYPE THYRISTOR OU TRIAC, AVEC IMPEDANCE D'ASSISTANCE A L'AUTO-ALLUMAGE.

L'invention se rapporte à la commande d'un thyristor sensible par l'établissement d'un court-circuit entre deux régions du semi-conducteur, et à son application à la constitution d'un dispositif bi-directionnel utilisé en relais statique.

On sait que, dans leur application aux relais statiques, les thyristors traditionnels, qui s'allument par injection de fronts raides de courant de gâchette de signe approprié, ont une tenue aux variations brusques de tension dV/dt et en montée en courant di/dt qui peut être insuffisante dans le cas où l'on recherche une grande sensibilité de commande. Pour remédier à cet inconvénient, on a proposé, dans la demande de brevet français déposée le 25.11.82 par le Centre National de la Recherche Scientifique, pour : "Structure de thyristor à allumage intrinsèque et son application à la réalisation d'un dispositif bi-directionnel", de réaliser un thyristor ultrasensible auto-allumable à la température ordinaire par l'effet du courant capacitif dû à la seule variation dV/dt de la tension d'alimentation normalement appliquée entre anode et cathode et de réaliser la commande d'un tel thyristor à allumage intrinsèque en créant un court-circuit entre gâchette et cathode inhibant la faculté d'auto-allumage, et en supprimant ce court-circuit pour provoquer l'auto-allumage au passage par zéro, par valeurs
croissantes, de la tension d'alimentation.

Un inconvénient du thyristor à allumage intrinsèque est
qu'il présente des difficultés majeures de réalisation inhérentes au principe même de son fonctionnement.

Il est, en effet, très difficile de réaliser de façon reproductible des thyristors suffisamment sensibles pour s'auto-
allumer pratiquement au passage par zéro de la tension du
réseau. En effet le courant de déplacement CdV/dt a une efficacité très réduite en ce qui concerne le déclenchement de
l'auto-allumage, en raison du fait que, d'une part, il est
uniformément réparti sur toute la surface de la jonction
centrale du thyristor, si bien que sa densité est réduite et
que, d'autre part, il décroît de façon hyperbolique à partir
du zéro de tension, à cause de la variation en $1/V^n$ avec
$\frac{1}{3} < n < \frac{1}{2}$ de la capacité de la jonction centrale. Compte tenu de
cette faible densité et de cette décroissance du courant de
déplacement, il faut alors réaliser le thyristor pour que,
d'une part, le gain du transistor NPN que comporte sa structure soit très élevé et que, d'autre part, les gains des
deux transistors NPN et PNP qu'elle comporte se conservent à
très bas niveau de courant. Une telle réalisation doit être
difficilement reproductible. Il convient de souligner d'autre part que l'hypersensibilité recherchée aux variations
dV/dt va dans le sens contraire de l'obtention d'une bonne
tenue aux variations dV/dt parasites.

L'invention propose de s'affranchir de cet inconvénient au
moyen d'un circuit de commande agencé pour assister l'auto-
allumage ou pour déclencher l'allumage et permettre ainsi
d'obtenir le déclenchement même avec un thyristor sensible
disponible sur le marché.

Le circuit de commande suivant l'invention comporte des
moyens interrupteurs aptes à établir un court-circuit

- 3 -

0110776

gâchette-cathode sur la structure sensible à semi-conducteur à commander sous l'action d'une commande extérieure et est caractérisé par une impédance d'assistance à l'auto-allumage reliant le pôle positif du circuit à sa sortie de commande de gâchette.

Suivant un premier mode de réalisation, ladite impédance est une résistance et lesdits moyens interrupteurs sont constitués par un transistor à effet de champ dont la grille est polarisée par une autre résistance à partir dudit pôle positif.

Suivant un second mode de réalisation, ladite impédance est un condensateur.

Dans un mode d'exécution préféré, lesdits moyens interrupteurs comprennent un transistor à effet de champ dont la grille est polarisée à partir de l'anode du thyristor à commander par une résistance et un photo-transistor court-circuitant ladite polarisation de grille lorsqu'il est activé par un signal lumineux.

Les diverses particularités, ainsi que les avantages de l'invention, apparaîtront clairement à la lumière de la description ci-après.

Au dessin annexé :

la figure 1 est un schéma de principe d'un circuit de commande d'une structure simple à semi-conducteur sensible conforme à un premier mode de réalisation de l'invention ;

la figure 2 représente le mode d'exécution d'un tel circuit dans le cas où la structure à commander est bi-directionnelle ; et

les figures 3 et 4 représentent deux circuits de commande à semi-conducteur, respectivement d'un dispo - sitif à deux thyristors et d'un triac, conformes à un second mode de réalisation de l'invention.

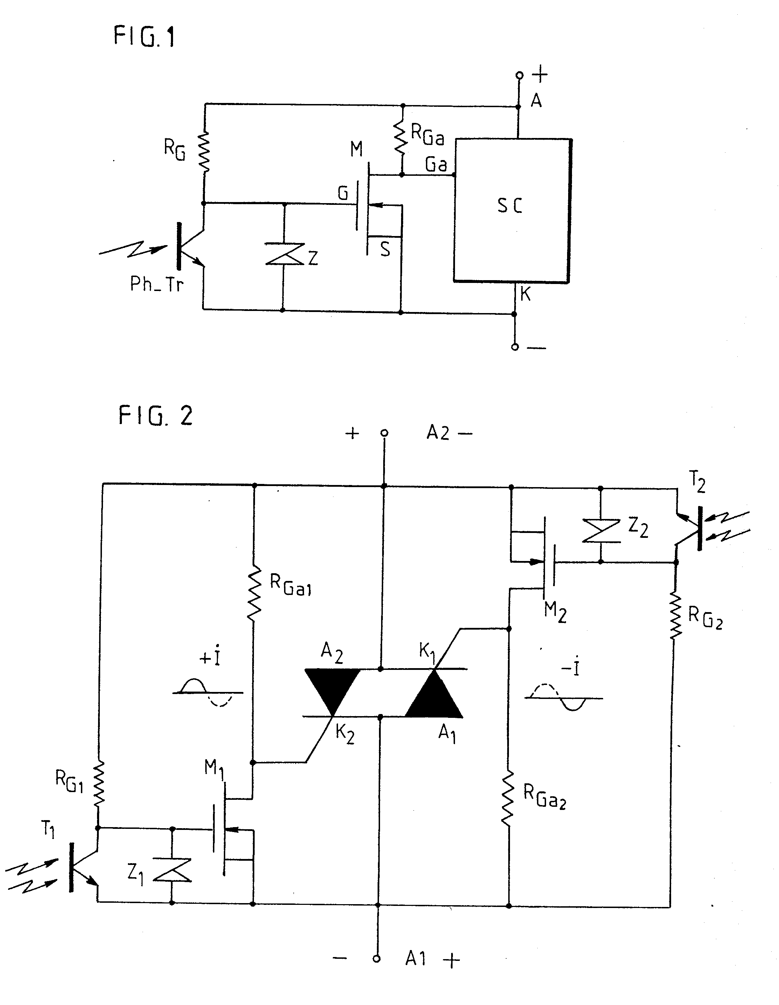

A la figure 1, on a représenté par un rectangle SC un dispositif à semi-conducteur apte à être bloqué par un court- circuit appliqué entre sa gâchette Ga et sa cathode K. Ce dispositif est alimenté par la tension alternative du secteur 220 V - 50 Hz, appliquée entre son anode A et sa cathode K. L'organe de commande, apte à établir un court- circuit entre Ga et K, est lui-même alimenté par le secteur entre A et K, c'est-à-dire que l'ensemble du montage est bipolaire. Cet organe comprend essentiellement un transistor MOS à canal N désigné par la référence M, une diode Zener Z, une résistance RG, un phototransistor Ph-T$_r$ activé par un signal lumineux de commande : ce phototransistor constituera de préférence la sortie d'un photocoupleur. La diode Z joue un rôle de protection du transistor MOS et a, par exemple, une tension de Zener d'environ 10 V. La résistance R$_G$ permet l'auto-polarisation de la grille du transistor MOS à partir du point chaud (+) du circuit de sortie. Lorsque le photocoupleur est activé, cette polarisation de grille est court-circuitée, si bien que le transistor MOS est bloqué. Par contre, lorsque le photocoupleur n'est pas activé, la grille du MOS se polarise et, dès que la tension V$_{GS}$ devient supérieure à la tension V$_{th}$ de seuil du transistor MOS, ce dernier se comporte comme un court-circuit de plus en plus franc et bloque donc SC.

On notera que SC est finalement normalement bloqué et que sa commande s'effectue par fermeture du relais de commande du photocoupleur, ce qui est avantageux dans les applications aux relais statiques.

En donnant à R$_G$ une valeur suffisamment élevée, par exemple 1 M Ω, on limite le courant parasite qui s'écoule à travers le phototransistor dans l'état conducteur du SC à une valeur efficace de l'ordre de 0,2 mA, ce qui est admissible. La valeur de 1 MΩ peut d'ailleurs être augmentée à condition que la constante de temps introduite dans le blocage de SC par la charge de la capacité d'entrée Ciss du transistor MOS, ajoutée au délai dû au seuil $V_{th}$ du transistor MOS, reste notablement inférieure au délai d'allumage du dispositif SC.

Suivant une particularité essentielle du montage décrit, une résistance supplémentaire $R_{Ga}$ de forte valeur, par exemple de l'ordre de 1 à 10 M $\Omega$, relie l'anode à la gâchette de SC, qui est un thyristor sensible ordinaire. Il en résulte que, dès que le signal lumineux de commande est appliqué, donc que le transistor MOS est bloqué, il s'établit un faible courant de gâchette de SC. Au moment du passage par zéro par valeurs croissantes de la tension d'alimentation, ce microcourant auxiliaire initialise l'allumage de SC, tandis que le courant de déplacement dans SC favorise l'extension de l'allumage à toute la surface de la jonction centrale de SC. Le courant de gâchette auxiliaire croît d'ailleurs en même temps que la tension d'alimentation, ce qui tend à compenser la décroissance hyperbolique du courant de déplacement.

On notera qu'un transistor MOS de modèle courant pourra sans difficulté écouler sans chute de tension notable le courant fourni par $R_{Ga}$, même lorsque celui-ci atteint sa valeur de crête de 300 µA correspondant à 1 M $\Omega$ sous 220 V eff.

Il convient de faire observer que, en cas d'allumage du thyristor sur un circuit de charge très inductif, pour lequel le courant monte très lentement, le courant d'assistance, du fait qu'il est croissant avec la tension tant que le thyristor n'est pas complètement allumé, fournit une assistance de plus en plus grande à l'allumage, ce qui supprime le risque de "décrochage" du thyristor. La valeur de $R_{Ga}$ peut se calculer si l'on redonne un seuil d'allumage $V_a$ pour le thyristor. On peut en effet montrer que $\Delta Q_a = V_a^2/2\omega V.R_{Ga}$, $\Delta Q_a$ étant la quantité de charges accumulée, depuis le passage à zéro de la tension d'alimentation, dans la base de la portion NPN du thyristor, quantité imposée pour un thyristor donné, V étant l'amplitude de la tension d'alimentation, et ω sa pulsation.

Dans le montage de la figure 2, on a représenté un dispositif bi-directionnel composé de deux structures de thyristor montées "tête-bêche", $A_1$, $K_1$ et $A_2$, $K_2$, dont chacune est commandée par un circuit du même type que celui de la figure 1.

$A-A_2$ et K désignent les anodes et les cathodes respectives. Les phototransistors $T_1$ et $T_2$ qui, lorsqu'ils sont passants, court-circuitent les MOS $M_1$ et $M_2$, sont eux-mêmes chacun commandés par des diodes électro-luminescentes - non figurées - alimentées par une source continue à travers une résistance et un organe interrupteur, mécanique ou électronique, de faible puissance. Les diodes électro-luminescentes de commande de $T_1$ et $T_2$ sont respectivement commandées à des instants correspondant respectivement au début d'une alternance positive et au début d'une alternance négative. Le temps de commande des diodes doit être supérieur au temps d'auto-allumage des thyristors. Ce temps de commande peut, sans inconvénients, être de plus longue durée et correspondre par exemple à un train d'alternance du secteur. Lorsque cesse la commande de ces diodes, le thyristor est déjà à l'état passant, donc, la tension aux bornes de l'ensemble est réduite à une valeur trop faible (par exemple 2 V) pour pouvoir mettre le MOS en conduction.
On notera que le système de commande présente une sécurité positive vis-à-vis des défaillances traditionnelles de ses composants. En effet, si la défaillance provient d'un défaut de mise en conduction du photocoupleur, le transistor MOS continue à assurer la sécurité par inhibition naturelle de l'auto-allumage à chaque alternance impliquée. Si la résistance $R_G$ qui doit tenir l'essentiel de la tension venait à se court-circuiter, cela se passerait en toute vraisemblance pour des tensions élevées sur le réseau. Dans ce cas, l'élévation de tension sur la grille du MOS entraînerait un perçage de cette grille (d'où un léger courant de fuite) mais aussi un claquage du MOS par excès de dissipation qui se traduirait par un court-circuit meilleur que le MOS conducteur. Seuls deux cas de défaillance présentent une sécurité négative, une rupture du phototransistor ou de la diode de Zener. En fait le phototransistor est protégé par la diode de Zener, donc sa rupture est très improbable. Quant à cette diode de Zener, elle ne peut claquer que par une élévation de tension qui entraîne en même temps un claquage du MOS et fait retomber dans le cas précédent.

On pourra envisager de remplacer le transistor MOS à enrichissement, donc normalement non conducteur, par un dispositif normalement conducteur. Ce dernier pourra être un transistor MOS du type à épuisement ou bien un transistor à effet de champ à jonction à canal P. On obtiendra ainsi une commande du semi-conducteur auto-allumable du type complémentaire de celle obtenue avec le transistor MOS à enrichissement. Comme on partira alors d'un état conducteur garantissant l'inhibition de l'auto-allumage de la structure thyristor, on devra commander la grille du transistor à effet de champ pour le bloquer et ainsi, autoriser l'auto-allumage.

Bien entendu, pour conserver la correspondance logique souhaitable entre le signal de commande et l'état conducteur du dispositif de puissance, on devra alors ajouter à l'entrée du transistor à effet de champ un étage logique inverseur de type connu en soi.

Cette variante possède l'avantage naturel d'une sécurité positive indépendante de la commande, donc totale, puisque tout défaut catastrophique du J-FET ou du MOS ne peut se traduire que par un court-circuit. Par contre, elle présente l'inconvénient d'une plus grande difficulté de réalisation du transistor à effet de champ et celui d'une plus grande complexité de la commande.

Ce dernier inconvénient peut toutefois être réduit en intégrant l'inverseur et la diode de zener sur le même cristal, ce qui est facile à réaliser.

$R_{Ga1}$ et $R_{Ga2}$ représentent les résistances d'assistance à

0110776

l'auto-allumage, qui jouent le même rôle que $R_{Ga}$ de la figure 1.

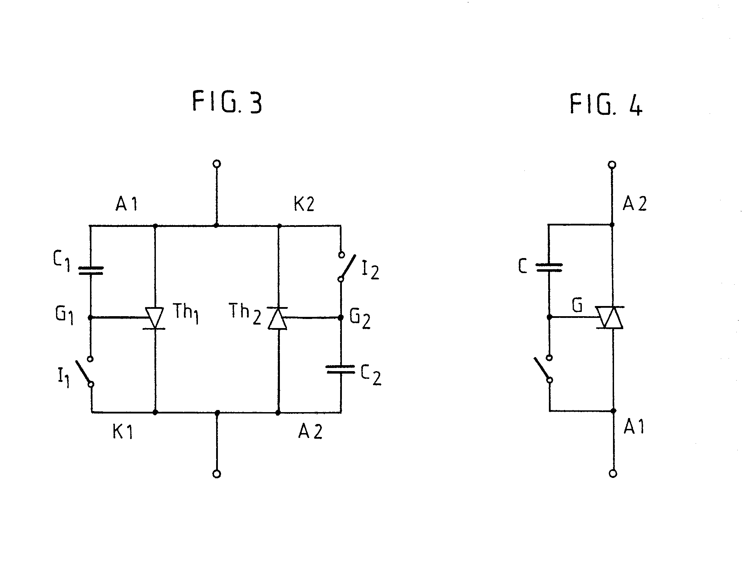

Dans le dispositif bi-directionnel de la figure 3, comportant deux thyristors $Th_1$ et $Th_2$ montés tête-bêche, des condensateurs $C_1$ et $C_2$ relient les anodes respectives $A_1$ et $A_2$ aux gâchettes respectives $G_1$ et $G_2$, tandis que celles-ci sont reliées aux cathodes respectives $K_1$ et $K_2$ par des interrupteurs respectifs $I_1$ et $I_2$.

Si l'on considère l'un quelconque des deux thyristors de ce montage, soit $Th_1$, lorsque l'interrupteur $I_1$ est ouvert, dès l'établissement de la tension en $A_1$, un courant $i = C_1 dV/dt$ est injecté dans la gâchette de $Th_1$. L'amorçage se produit dès que ce courant devient suffisant, donc après chaque passage par zéro par valeurs croissantes de la tension d'alimentation. Lorsque $I_1$ est fermé, le courant $C_1 dV/dt$ est détourné de la jonction gâchette-cathode et, le potentiel de la gâchette étant sensiblement le même que celui de la cathode, le thyristor ne peut plus s'amorcer.

On notera qu'au moment de la première mise en conduction, le courant de décharge ne peut dépasser $C_1 dV/dt$, donc il est faible et la mise en série avec le condensateur d'une résistance de limitation de ce courant est inutile.

Pendant la période de blocage, en cas de parasite en dV/dt, le courant circule à travers la résistance interne de $I_1$ et, par conséquent, la protection du thyristor contre un allumage intempestif provenant de Cl est parfaitement assurée, à condition toutefois que cette résistance interne soit beaucoup plus faible que la résistance d'accès à la jonction centrale du thyristor. Par exemple, pour un dV/dt de 1000 V/µs et pour $C_1 = C_2 = 100$ pF, l'interrupteur en court-circuit devra écouler un courant de 100 mA, tout en gardant une tension maximum à ses bornes de 0,2 V, ce qui impose une résistance statique de 2Ω pour le transistor MOS à l'état conducteur. Il faut noter, par ailleurs, que l'interrupteur doit très rapidement établir cette valeur de résistance, car cela doit se faire avant l'allumage du thyristor, qui sera relativement rapide lorsqu'il est déclenché par le courant fourni par une capacité.

Le dispositif fonctionnera correctement avec des thyristors sensibles. Avec des thyristors ordinaires, le condensateur d'assistance devrait avoir une valeur importante et, par conséquent, le courant de fuite qui circulerait dans le dispositif et dans la charge à l'état bloqué serait trop important.

Le montage à triac représenté à la figure 4 fonctionne de la même façon.

On notera que, par rapport aux montages à résistance d'assistance, le montage à condensateur d'assistance à l'allumage fournit un temps d'allumage plus bref (l'injection de courant dans la gâchette du thyristor étant plus brutale). Dans la mesure où la résistance de l'interrupteur fermé est bien définie et très faible (contact électro-mécanique, par exemple) ces montages sont intéressants et offrent une bonne protection vis à vis des parasites. Par contre, les montages à résistance d'assistance peuvent fonctionner avec un interrupteur constitué par un transistor MOS de modèle courant, ce qui est très avantageux dans certaines applications.

On pourrait envisager d'utiliser, comme impédance d'assistance à l'allumage, un ensemble résistance-capacité en parallèle, pour réaliser un compromis entre les caractéristiques des deux types de montages.

Il va de soi que diverses modifications pourront être apportées aux montages décrits et représentés, sans s'écarter de l'esprit de l'invention.

Revendications de brevet

1. Circuit de commande d'un dispositif à semi-conducteur (SC ou $Th_1$, $Th_2$), comportant des moyens interrupteurs (M ou $I_1$, $I_2$) aptes à établir un court-circuit entre la gâchette et la cathode dudit dispositif sous l'action d'une commande extérieure, caractérisé par une impédance d'assistance à l'auto-allumage reliant le pôle positif du circuit (A, $A_1$ ou $A_2$) à sa sortie de commande de gâchette (Ga, $G_1$ ou $G_2$).

2. Circuit de commande selon la revendication 1, caractérisé en ce que ladite impédance est une résistance ($R_{Ga}$, $R_{Ga1}$ ou $R_{Ga2}$) et lesdits moyens interrupteurs sont constitués par un transistor à effet de champ (M) dont la grille est polarisée par une autre résistance ($R_G$, $R_{G1}$ ou $R_{G2}$) à partir dudit pôle positif et par un phototransistor (Ph-Tr) relié audit transistor à effet de champ de façon à court-circuiter ladite polarisation lorsqu'il est activé par un signal lumineux.

3. Circuit de commande selon la revendication 2, caractérisé en ce que ladite résistance ($R_{Ga}$) d'assistance à l'auto-allumage à une valeur de l'ordre de un ou plusieurs mégohms.

4. Circuit de commande selon la revendication 1, caractérisé en ce que ladite impédance est un condensateur (C ou $C_1$, $C_2$).

5. Circuit de commande selon la revendication 2, caractérisé en ce que ledit signal lumineux est établi au moment d'un passage à zéro de la tension d'alimentation et pour une durée supérieure au temps d'auto-allumage du dispositif à semi-conducteur.

6. Circuit de commande selon la revendication 5, caractérisé en ce que ledit transistor à effet de champ est

- 11 -

0110776

dimensionné pour être apte à couper les courants d'allumage qui circulent dans ledit dispositif à semi-conducteur.

7. Circuit de commande selon la revendication 2, caractérisé en ce que ledit transistor à effet de champ est du type MOS à enrichissement.

8. Circuit de commande selon la revendication 2, caractérisé en ce que ledit transistor à effet de champ est du type MOS à épuisement ou du type à jonction à canal P et est associé à son entrée à un circuit logique inverseur.

FIG.1

FIG. 2

FIG. 3

FIG. 4

# 0110776

**Office européen des brevets**

## RAPPORT DE RECHERCHE EUROPEENNE

EP  83 40 2258

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | NEW ELECTRONICS, vol. 10, no. 1, 11 janvier 1977, pages 40,43, Juniper Journals Ltd., Londres, GB G.A. STEVENS: "A.c. full-wave static switch" * En entier * | 1,2,4 | H 03 K   17/725 H 03 K   17/78 |
| | --- | | |
| A | FR-A-2 443 172 (OKI ELECTRIC INDUSTRY) * Page 4, lignes 22-35; figure 3 * | 2,6,8 | |
| | --- | | |
| A | US-A-3 663 838 (REIMERS) * Colonne 2, ligne 39 - colonne 3, ligne 26; figure 2 * | 2 | |
| | ----- | | |

**DOMAINES TECHNIQUES RECHERCHES (Int. Cl. ³)**

H 03 K
H 02 M

Le présent rapport de recherche a été établi pour toutes les revendications

| Lieu de la recherche LA HAYE | Date d'achèvement de la recherche 02-03-1984 | Examinateur CANTARELLI R.J.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant